# EUROPÄISCHE PATENTSCHRIFT

(11) **EP 0 847 535 B1**
(45) Veröffentlichungstag und Bekanntmachung des Hinweises auf die Patenterteilung: **21.06.2006**
(21) Anmeldenummer: 96929120.2
(22) Anmeldetag: 27.08.1996
(51) Int. Cl.: G01R 33/48

(54) **VERFAHREN UND VORRICHTUNG ZUR BILDUNG EINER ABBILDUNG MIT KERNSPINRESONANZ**
METHOD AND APPARATUS FOR NUCLEAR MAGNETIC RESONANCE IMAGING
PROCEDE ET DISPOSITIF DE FORMATION D'IMAGES PAR RESONANCE MAGNETIQUE NUCLEAIRE

(30) Priorität: 28.08.1995 AT 144995
(43) Veröffentlichungstag der Anmeldung: 17.06.1998
(73) Patentinhaber: SZELES, Josef Constantin, A-1190 Wien (AT)
(72) Erfinder: SZELES, Josef, Constantin, A-1190 Wien (AT); MESZAROS, Sándor, H-4030 Debrecen (HU)
(86) Internationale Anmeldenummer: PCT/AT1996/000155
(87) Internationale Veröffentlichungsnummer: WO 1997/008564

(56) Entgegenhaltungen:
- EP-A- 0 481 211
- WO-A-95/03550
- US-A- 4 442 404
- US-A- 5 057 776
- MAGNETIC RESONANCE IN MEDICINE, Bd. 30, Nr. 2, 1.August 1993, Seiten 221-230, XP000385356 MACOVSKI A ET AL: "NOVEL APPROACHES TO LOW-COST MRI"
- MAGNETIC RESONANCE IN MEDICINE, Bd. 15, Nr. 3, 1.September 1990, Seiten 386-391, XP000170518 STEPISNIK J ET AL: "NMR IMAGING IN THE EARTH'S MAGNETIC FIELD"
- PHYSICS IN MEDICINE AND BIOLOGY, Bd. 37, Nr. 11, 1.November 1992, Seiten 2133-2138, XP000309569 SETON H C ET AL: "DC SQUID-BASED NMR DETECTION FROM ROOM TEMPERATURE SAMPLES"

## Beschreibung

Die Erfindung bezieht sich auf ein Verfahren zur Bildung einer Abbildung eines Bereiches eines Körpers durch Erfassung von durch Kernspinresonanz entstehenden Magnetfeldern mit einem Gradiometer und Verarbeitung der dabei mit diesem Gradiometer erhaltenen Signale in einer Datenverarbeitungseinrichtung zu einer Abbildung, wobei der Körper zunächst einem homogenen polarisierenden statischen Magnetfeld ausgesetzt wird und daraufhin die Feldstärke dieses Magnetfeldes vermindert wird, vorzugsweise auf Null gebracht wird, und ein weiteres Magnetfeld, dessen Feldlinien quer zu den Feldlinien des genannten polarisierenden Magnetfeldes, verlaufen und in dem räumliche Gradienten der Feldstärke vorliegen, auf den Körper zur Einwirkung gebracht wird.

Die Erfindung bezieht sich auch auf eine Vorrichtung zur Durchführung des erfindungsgemäßen Verfahrens.

Es sind Verfahren bekannt (WO 95/03550 A), bei denen ein Körper, von dem mittels Kernspinresonanz eine Abbildung hergestellt werden soll, ständig einem homogenen statischen Magnetfeld ausgesetzt wird, dem ein weiteres Magnetfeld, in welchem räumliche Gradienten vorliegen, überlagert ist, und auch ein hochfrequentes elektromagnetisches Feld auf den Körper einwirken gelassen wird, wobei die Amplitude des hochfrequenten Feldes im betrachteten Körperbereich möglichst konstant gehalten wird und die Frequenz dieses Feldes korxespbndierend zum Gradienten des weiteren Magnetfeldes entsprechend den Resonanzbedingungen der an verschiedenen Stellen des Körpers vorliegenden Atome etwas variiert wird. Die durch Kernspinresonanz in Atomen des abzubildenden Körpers erzeugten Magnetfeldänderungen werden von einem Magnetfeldsensor erfasst, und die von diesem dabei gelieferten Signale werden mittels einer Datenverarbeitungseinrichtung und einer Abbildungseinheit zu einer Abbildung umgeformt. Als Magnetfeldsensor wurde dabei auch ein SQUID-Gradiometer in Betracht gezogen. Es ergeben sich bei diesen bekannten verfahren durch die Einwirkung des hochfrequenten Feldes verschiedene Probleme, wobei hierzu insbesondere die oft unerwünschte Erwärmung durch das Höchfrequenzfeld und die durch den Skin-Effekt entstehende Verminderung der Feldanplitude des Hochfrequenzfeldes im Inneren des Körpers genannt werden können. Derartige Verfahren erfordern zu ihrer praktischen Realisierung auch einen verhältnismäßig großen Aufwand.

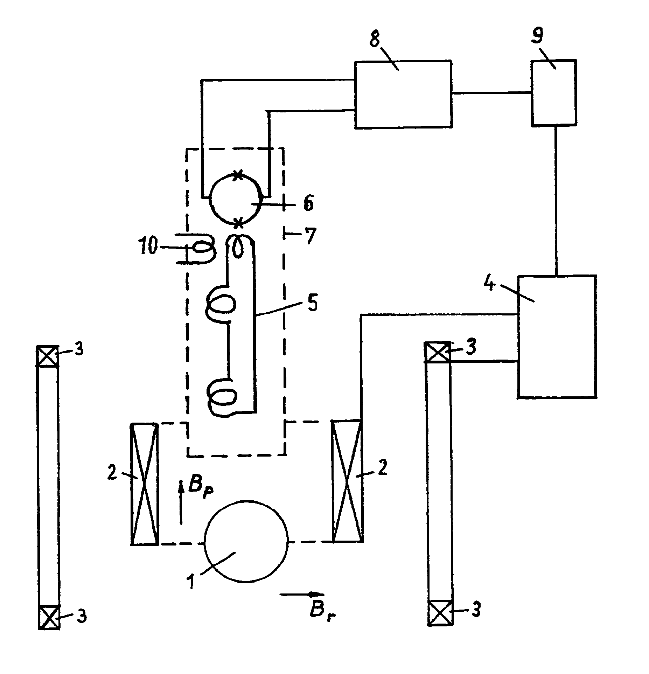

In dem Aufsatz "Novel Approaches to Low-Cost MRI" von Macovski und Conolly, veröffentlicht in Magnetic Resonance in Medicine 30 (1993) August, No. 2, sind eine Reihe gedanklicher Über legungen erörtert, die auf Techniken zielen, die mit geringerem Aufwand Abbildungen mittels Kernspinresonanz realisieren lassen. Es ist im Rahmen dieser Überlegungen vorgesehen, die zu untersuchenden Körper zuerst einem polarisierenden Magnetfeld auszusetzen und dann ein weiteres Magnetfeld auf die betreffenden Körper einwirken zu lassen, wobei dieses weitere Magnetfeld ein oszillatorisches oder statisches Magnetfeld ist. Unter Einfluss dieses weiteren Magnetfeldes werden die durch Kernspinresonanz erhaltenen Signale zur Erzielung der Abbildung erfasst. Zum Erfassen dieser Signale wird auch ein Gradiometer in Betracht gezogen. Es ist in dieser Aufsatz ausgeführt, dass durch den Einsatz eines oszillatorischen Magnetfeldes als weiteres Magnetfeld Nachteile vermieden werden können, die bei einem statischen Magnetfeld durch Inhomogenitäten desselben entstehen.

In dem Artikel "NMR Imaging in the Earth's Magnetic Field" von Stepisnik et al., Magnet Resonance in Medicine 15 (1990) September, No. 3, sind Verfahren zur Abbildung mittels Kernspinresonanz beschrieben, bei denen zuerst auf die zu untersuchenden Körper ein polarisierendes Magnetfeld einwirkt, und dann unter Einfluss des Erdmagnetfeldes die durch Kernspinresonanz erhaltenen Signale zur Erzielung einer Abbildung erfasst werden. Es wird auch ein Gradiometer zur Erfassung dieser Signale in Betracht gezogen.

Es ist ein ziel der Erfindung, ein anders konzipiertes Verfahren eingangs erwähnter Art sowie eine Vorrichtung hierfür zu schaffen, bei welchen die nachteiligen Probleme der bekannten Techniken weitgehend behoben sind.

Das erfindungsgemäße Verfahren eingangs erwähnter Art ist dadurch gekennzeichnet, dass das weitere Magnetfeld ein statisches Magnetfeld ist und die in Richtung der Feldlinien des polarisierenden Magnetfeldes verlaufende Komponente der im Körper durch Kernspinresonanz entstehenden Magnetfelder mit einem hochempfindlichen SQUID-Gradiometer, dessen Detektionsspulen keine Signal gebende induktive Kopplung mit dem polarisierenden Magnetfeld haben und dessen Detektionsspulen auch keine Signal gebende induktive Kopplung mit dem weiteren statischen Magnetfeld haben, erfasst werden, und dass ein polarisierendes Magnetfeld mit einer im Bereich von 10 mT bis 100 mT liegenden Feldstärke angewendet wird. Durch dieses Verfahren kann der vorstehenden Zielsetzung gut entsprochen werden. Es bedarf keines Hochfrequenzfeldes, und es wird mit verhältnismäßig geringen Feldstärken des polarisierenden Magnetfeldes gearbeitet, wobei trotzdem ein günstiges Signal-Rausch-Verhältnis, erzielbar ist. Es wird der Kernspin der Atome des abzubildenden Körperbereiches durch das polarisierende Magnetfeld polarisiert, dann dieses Magnetfeld vermindert oder abgeschaltet und das weitere Magnetfeld, welches quer zum polarisierenden Magnetfeld gerichtet ist, einwirken gelassen, wodurch sich im weiteren Magnetfeld eine Präzessionsbewegung des Kernspins ergibt, die ihrerseits ein Magnetfeld bildet, das mit dem SQUID-Gradiometer erfasst wird. Es ergibt sich aus der Präzessionsbewegung ein Amplitudermaximum des mit dem SQUID-Gradiometer in der Richtung des polarisierenden Magnetfeldes (z-Richtung) erfassbaren Magnetfeldes bzw. Signals. Die vom SQUID-Gradiometer abgegebenen Signale werden mit einer Datenverarbeitungseinrichtung zu einer Abbildung verarbeitet. Durch das SQUID-Gradiometer ergibt sich eine hohe Empfindlichkeit besonders im hier wichtigen Niederfrequenzbereich von Gleichstrom bis etwa 10 kHz. Die Konfiguration des Gradiometers, welches erster, zweiter oder höherer, insbesondere dritter, Ordnung sein kann, wird so gewählt, dass die Detektionsspulen des Gradiometers auch keine Signal gebende induktive Kopplung mit dem weiteren statischen Magnetfeld haben.

Solcherart wird eine Überlastung, des SQUID sicher vermieden, und es werden die Totzeiten reduziert, wodurch ein rascheres Arbeiten möglich wird.

Es ist günstig, wenn eine Justierung der Entkopplung zwischen dem polarisierenden Magnetfeld und dem weiteren statischen Magnetfeld einerseits und den Detektionsspulen andererseits mittels einer zusätzlich zu den Detektionsspulen des SQUID-Gradiometers vorgesehenen Kompensationsspule vorgenommen wird, der ein vom Strom des Polarisationsmagneten und/oder vom Strom der für das weitere statische Magnetfeld vorgesehenen Magneteinrichtung abhängiger Strom zugeführt wird.

Die gute Empfindlichkeit des SQUID bei niederen Frequenzen kann zur Ausschaltung von störenden Hochfrequenzeinflüssen durch Ausfiltern der Hochfrequenz unterstützt werden. Durch entsprechende Konfiguration der Eingangsspulen des Magnetometers kann inan hinsichtlich störender externer Felder dafür sorgen, dass nur die niederfrequenten Anteile der auf das Gradiometer einwirkenden Felder erfasst werden.

Hinsichtlich der Polarisationszeit sieht man vorzugsweise vor, dass das homogene polarisierende Magnetfeld während einer Zeitspanne von etwa dem Zwei- bis Dreifachen der Längsrelaxionszeit T₁ konstant aufrechterhalten und dann vermindert, vorzugsweise abgeschaltet, wird.

Die erfindungsgemäße Vorrichtung zur Bildung einer Abbildung eines Bereiches eines Körpers durch Erfassung von durch Kernspinresonanz entstehenden Magnetfeldern mit einem ein homogenes statisches Magnetfeld bildenden Polarisationsmagneten, welcher an eine Schaltvorrichtung zur Verminderung oder Abschaltung des Magnetflusses nach der Polarisationsphase angeschlossen ist, und mit einer zur Bildung eines weiteren, quer zum Polarisationsfeld verlaufenden, räumliche Gradienten aufweisenden. Magnetfeldes geeigneten Magneteinrichtung, ist dadurch gekennzeichnet, dass zur Durchführung des Verfahrens gemäß der Erfindung die genarmte Magneteinrichtung zur Erzeugung eines statischen Magnetfeldes ausgebildet und gleichfalls an eine Schalteinrichtung angeschlossen ist, dass der Polarisationsmagnet für eine Feldstärke im Bereich von 10 mT bis 100 mT ausgebildet ist, und dass die Vorrichtung ein hochempfindliches SQUID-Gradiometer, das zur Erfassung von Feldänderungen in Richtung des Polarisationsfeldes ausgebildet ist, aufweist, wobei die Detektionsspulen des SQUID-Gradiometers keine Signal gebende induktive Kopplung mit dem Magnetfeld des Polarisationsmagneten und auch keine Signal gebende induktive Kopplung mit dem von der Magneteinrichtung erzeugten statischen Magnetfeld haben, und die Vorrichtung weiter eine Datenverarbeitungseinrichtung zur Herstellung einer Abbildung aus den Signalen des SQUID-Gradiometers besitzt. Es ist dabei für die Entkopplung vorteilhaft, wenn das Gradiometer neben den Eingangsspulen eine justierbare Kompensationsspule aufweist, der ein vom Strom des Polarisationsmagneten und/oder vom Strom der Magneteinrichtung bestimmter Kampensationsstrom zuführbar ist.

In der Zeichnung ist ein Ausführungsbeispiel einer Vorrichtung zur Durchführung- des erfindungsgemäßen Verfahrens schematisch dargestellt.

In der Zeichnung ist der zu untersuchende Körper mit 1 bezeichnet, der Polarisationsmagnet mit 2, das Magnetsystem zur Bildung des weiteren Magnetfeldes mit 3, eine Schalteinrichtung für den Polarisationsmagneten 2 und das Magnetsystem 3 mit 4 und ein Gradiometer mit 5. Das Gradiometer 5 ist ein SQUID-Gradiometer mit einem SQUID 6 und einem unmagnetischen Kryostaten 7. Mit 8 ist eine Steuereinrichtung für das SQUID 6 und mit 9 eine Datenverarbeitungseinrichtung zur Bildung einer Abbildung aus den Gradiometersignalen und zur Steuerung der Magnetfelder bezeichnet. Einer bevorzugt vorgesehenen justierbaren kompensationsspule 10 wird ein von den Strömen der Magneteinrichtungen 2 bzw. 3 abhängiger Kompensationsstrom zugeführt.

Der Pfeil Bₚ zeigt die Richtung des polarisierenden Magnetfeldes und der Pfeil Bᵣ die Richtung des obgenannten weiteren Magnetfeldes an.

## Patentansprüche

1. verfahren zur Bildung einer Abbildung eines Bereiches eines Körpers durch Erfassung von durch Kernspinresonanz entstehenden Magnetfeldern mit einem Gradiometer und Verarbeitung der dabei mit diesem Gradiometer erhaltenen Signale in einer Datenverarbeitungseinrichtung zu einer Abbildung, wobei der Körper zunächst einem homogenen polarisierenden statischen Magnetfeld ausgesetzt wird und daraufhin die Feldstärke dieses Magnetfeldes vermindert wird, vorzugsweise auf Null gebracht wird, und ein weiteres Magnetfeld, dessen Feldlinien quer zu den Feldlinien des genannten polarisierenden Magnetfeldes verlaufen und in dem räumliche Gradienten der Feldstärke vorliegen, auf den Körper zur Einwirkung gebracht wird, **dadurch gekennzeichnet, dass** das weitere Magnetfeld ein statisches Magnetfeld ist und die in Richtung der Feldlinien des polarisierenden Magnetfeldes verlaufende Komponente der im Körper durch Kernspinresonanz entstehenden Magnetfelder mit einem hochempfindlichen SQUID-Gradiometer, dessen Detektionsspulen keine Signal gebende induktive Kopplung mit dem polarisierenden Magnetfeld haben und dessen Detektionsspulen auch keine Signal gebende induktive Kopplung mit dem weiteren statischen Magnetfeld haben, erfasst werden, und dass ein polarisierendes Magnetfeld mit einer im Bereich von 10 mT bis 100 mT liegenden Feldstärke angewendet wird.

2. Verfahren nach Anspruch 1, **dadurch gekennzeichnet, dass** eine Justierung der Entkopplung zwischen dem polarisierenden Magnetfeld und dem weiteren statischen Magnetfeld einerseits und den Detektionsspulen andererseits mittels einer zusätzlich zu den Detektionsspulen des SQUID-Gradiometers vorgesehenen Kompensationsspule vorgenommen wird, der ein vom Strom des Polarisationsmagneten und/oder vom Strom der für das weitere statische Magnetfeld vorgesehenen Magneteinrichtung abhängiger Strom zugeführt wird.

3. Verfahren nach einem der vorhergehenden Ansprüche, **dadurch gekennzeichnet, dass** das homogene polarisierende Magnetfeld während einer Zeitspanne von etwa dem Zwei- bis Dreifachen der Längsrelaxionszeit T₁ konstant aufrechterhalten und dann vermindert, vorzugsweise abgeschaltet, wird.

4. Verfahren nach einem der vorhergehenden Ansprüche, **dadurch gekennzeichnet, dass** nur die niederfrequenten Anteile der auf das SQUID-Gradiometer einwirkenden Felder erfasst werden.

5. Vorrichtung zur Bildung einer Abbildung eines Bereiches eines Körpers durch Erfassung von durch Kernspinresonanz entstehenden Magnetfeldern mit einem ein homogenes statisches Magnetfeld (Bₚ) bildenden Polarisationsroagneten (2), welcher an eine. Schaltvorrichtung (4) zur Verminderung oder Abschaltung des Magnetflusses nach der Polarisationsphase angeschlossen ist, und mit einer zur Bildung eines weiteren, quer zum Polarisationsfeld verlaufenden, räumliche Gradienten aufweisenden Magnetfeldes (Bᵣ) geeigneten Magneteinrichtung (3), **dadurch gekennzeichnet, dass** zur Durchführung des Verfahrens nach einem der vorhergehenden Anspruche die genannte Magneteinrichtung (3) zur Erzeugung eines statischen Magnetfeldes ausgebildet und gleichfalls an eine Schalteinrichtung angeschlossen ist, dass der Polarisationsmagnet für eine Feldstärke im Bereich von 10 mT bis 100 mT ausgebildet ist, und dass die Vorrichtung ein hochenpfindliches SQUID-Gradiometer (5), das zur Erfassung von Feldänderungen in Richtung des Polarisationsfeldes ausgebildet ist, aufweist, wobei die Detektionsspulen des SQUID-Gradiometers keine Signal gebende induktive Kopplung mit dem Magnetfeld des Polarisationsmagneten (2) und auch keine Signal gebende induktive Kopplung mit dem von der Magneteinrichtung (3') erzeugten statischen Magnetfeld haben, und die Vorrichtung weiter eine Datenverarbeitungseinrichtung zur Herstellung einer Abbildung aus den Signalen des SQUID-Gradiometers besitzt,

6. Vorrichtung nach Anspruch 5, **dadurch gekennzeichnet, dass** das SQUID-Gradiometer zusätzlich zu den Detektionsspulen eine justierbare Kompensationsspule (10) aufweist, der ein vom Strom des Polarisationsmagneten und/oder vom Strom der Magneteinrichtung bestimmter Kompensationsstrom zuführbar ist.

## Claims

1. A method for imaging a region of a body by sensing magnetic fields forming on account of nuclear magnetic resonance, by means of a gradiometer, and processing the signals obtained with this gradiometer in a data processing device to give an image, wherein at first the body is subjected to a homogeneous polarizing static magnetic field, and subsequently the field intensity of this magnetic field is reduced, preferably is brought to zero, and a further magnetic field whose field lines extend transversely to the field lines of the said polarizing magnetic field and in which spatial gradients of the field intensity are present is caused to act on the body, **characterised in that** the further magnetic field is a static magnetic field, and **in that** the component of the magnetic fields thereby forming in the body on account of nuclear magnetic resonance which extends in the direction of the field lines of the polarizing magnetic field is sensed by a highly sensitive SQUID gradiometer whose detection coils do not have any signal emitting inductive coupling with the polarizing magnetic field, and whose detection coils do not have any signal emitting inductive coupling with the further static magnetic field, either, and **in that** a polarizing magnetic field having a field intensity in the range of from 10 mT to 100 mT is used.

2. A method according to claim 1, **characterised in that** an adjustment of the decoupling between the polarizing magnetic field and the further static magnetic field, on the one hand, and the detection coils, on the other hand, is effected by a compensation coil provided in addition to the detection coils of the SQUID gradiometer, to which compensation coil a current is supplied which depends on the current of the polarization magnet and/or on the current of the magnetic device provided for the further static magnetic field.

3. A method according to any one of the preceding claims, **characterised in that** the homogeneous polarizing magnetic field is kept constant for a span of time that is approximately twice to three times that of the longitudinal relaxation time T₁, and subsequently is reduced, preferably switched off.

4. A method according to any one of the preceding claims, **characterised in that** only the low frequency portions of the fields acting on the SQUID-gradiometer are sensed.

5. An arrangement for imaging a region of a body by sensing magnetic fields forming on account of nuclear magnetic resonance, comprising a polarization magnet (2) forming a homogeneous static magnetic field (Bₚ), which polarization magnet is connected to a switching means (4) for reducing or switching off the magnetic flow after the polarization phase, and a magnetic device (3) suitable for forming a further magnetic field (Bᵣ) extending transversely to the field of polarization and including spatial gradients, **characterised in that** for carrying out the method according to any one of the preceding claims, the said magnetic device (3) is designed for producing a static magnetic field and likewise is connected to a switching means, **in that** the polarization magnet is designed for a field intensity in the range of from 10 mT to 100 mT, and **in that** the arrangement comprises a highly sensitive SQUID-gradiometer (5) designed to sense field changes in the direction of the polarization field, wherein the detection coils of the SQUID-gradiometer do not have any signal-emitting inductive coupling with the magnetic field of the polarization magnet (2) and do not have any signal-emitting inductive coupling with the static magnetic field produced by the magnetic device (3) either, and the arrangement further comprises a data processing device for forming an image from the SQUID-gradiometer signals.

6. An arrangement according to claim 5, **characterised in that** the SQUID-gradiometer comprises an adjustable compensation coil (10) in addition to the detection coils, a compensation current determined by the current of the polarization magnet and/or by the current of the magnetic device being feedable to said adjustable compensation coil.

## Revendications

1. Procédé de formation d'images d'une zone d'un corps par la saisie de champs magnétiques constitués par résonance magnétique nucléaire avec un gradiomètre et traitement des signaux obtenus avec ce gradiomètre dans un dispositif de traitement de données pour obtenir une image, le corps étant d'abord exposé à un champ magnétique statique homogène et polarisant et ensuite l'intensité de champ de ce champ magnétique étant réduite en étant de préférence ramenée à zéro et le corps étant soumis à un autre champ magnétique dont les lignes de champ s'étendent transversalement par rapport aux lignes de champ du champ magnétique polarisant cité et sont présentes dans le gradient spatial de l'intensité de champ, **caractérisé en ce que** l'autre champ, magnétique est un champ magnétique statique et que la composante des champs magnétiques constitués dans le corps par résonance magnétique nucléaire, laquelle composante s'étend dans la direction des lignes de champs du champ magnétique polarisant, est saisie par un gradiomètre SQUID ultrasensible dont les bobines de détection ne font pas l'objet d'un couplage inductif donnant un signal avec le champ magnétique polarisant et dont les bobines de détection ne font pas non plus l'objet d'un couplage inductif donnant un signal avec l'autre champ magnétique statique et **en ce qu'**un champ magnétique polarisant avec une intensité de champ située dans la zone de 10 mT à 100 mT est utilisé.

2. Procédé selon la revendication 1, **caractérisé en ce qu'**un ajustement du découplage entre le champ magnétique polarisant et l'autre champ magnétique statique d'une part et les bobines de détection d'autre part est réalisé au moyen d'une bobine de compensation, laquelle est prévue en plus des bobines de détection du gradiomètre SQUID et à laquelle est amené un courant dépendant du courant de l'aimant de polarisation et/ou du courant du dispositif magnétique prévu pour l'autre champ magnétique statique.

3. Procédé selon l'une quelconque des revendications précédentes, **caractérisé en ce que**, pendant une période d'environ le double jusqu'au triple du temps de relaxation longitudinale T₁, le champ magnétique homogène et polarisant est maintenu constant puis est réduit et de préférence mis hors service.

4. Procédé selon l'une quelconque des revendications précédentes, **caractérisé en ce que** seules les quotes-parts à basse fréquence des champs agissant sur le gradiomètre SQUID sont saisies.

5. Dispositif de formation d'images d'une zone d'un corps par la saisie de champs magnétiques constitués par résonance magnétique nucléaire avec un aimant de polarisation (2) qui forme un champ magnétique homogène statique (Bp) et qui est raccordé à un dispositif de commutation (4) pour réduire ou pour arrêter le flux magnétique après la phase de polarisation et avec un dispositif magnétique (3) adapté pour la formation d'un autre champ magnétique (Br) s'étendant transversalement par rapport au champ de polarisation et comprenant des gradients spatiaux, **caractérisé en ce que**, pour la réalisation du procédé selon l'une quelconque des revendications précédentes, le dispositif magnétique cité (3) est configuré pour générer un champ magnétique statique et est également raccordé à un dispositif de commutation, **en ce que** l'aimant de polarisation est configuré pour une intensité de champ située dans la plage de 10 mT à 100 mT et **en ce que** le dispositif comprend un gradiomètre SQUID ultrasensible (5) qui est configuré pour la saisie de modifications de champs en direction du champ de polarisation, alors que les bobines de détection du gradiomètre SQUID de font pas l'objet d'un couplage inductif donnant un signal avec le champ magnétique de l'aimant de polarisation (2) et ne font pas non plus l'objet d'un couplage inductif donnant un signal avec le champ magnétique statique généré par le dispositif magnétique (3) et que le dispositif comprend par ailleurs un dispositif de traitement de données pour la réalisation d'une image à partir des signaux du gradiomètre SQUID.

6. Dispositif selon la revendication 5, **caractérisé en ce que** le gradiomètre SQUID comprend, en plus des bobines de détection, une bobine de compensation ajustable (10), à laquelle peut être amené un courant de compensation déterminé par le courant de l'aimant de polarisation et/ou par le courant du dispositif magnétique.
